# FASCICULE DE BREVET EUROPEEN

(11) **EP 1 851 811 B1**
(45) Date de publication et mention de la délivrance du brevet: **08.05.2019**
(21) Numéro de dépôt: 06708432.7
(22) Date de dépôt: 21.02.2006
(51) Int. Cl.: H01L 51/54

(54) **DIODE ORGANIQUE ELECTROLUMINESCENTE A COUCHES DOPEES**
ORGANISCHE LEUCHTDIODE MIT DOTIERTEN SCHICHTEN
ORGANIC LIGHT-EMITTING DIODE WITH DOPED LAYERS

(30) Priorité: 22.02.2005 FR 0550490
(43) Date de publication de la demande: 07.11.2007
(73) Titulaire: Commissariat à l'Energie Atomique et aux Energies Alternatives, 75015 Paris (FR)
(72) Inventeur: CINA, Salvatore, F-38000 Grenoble (FR); DOYEUX, Henri, F-38140 Beaucroissant (FR); VAUFREY, David, F-35000 Rennes (FR); BETTINELLI, Armand, F-COUBLEVIE 38500 (FR)
(74) Mandataire: Talbot, Alexandre
(86) Numéro de dépôt international: PCT/EP2006/060157
(87) Numéro de publication internationale: WO 2006/089901

(56) Documents cités:
- EP-A2- 0 977 288
- US-A1- 2002 055 015
- US-A1- 2002 164 416
- US-A1- 2003 072 967
- US-A1- 2003 143 428
- KIDO JUNJI ET AL: "Bright organic electroluminescent devices having a metal-doped electron-injecting layer" APPLIED PHYSICS LETTERS, AIP, AMERICAN INSTITUTE OF PHYSICS, MELVILLE, NY, US, vol. 73, no. 20, 16 novembre 1998 (1998-11-16), pages 2866-2868, XP012021409 ISSN: 0003-6951

## Description

L'invention concerne un procédé de réalisation d'une diode électroluminescente.

Une diode électroluminescente réalisée par le procédé inventif peut être fournie dans les panneaux d'éclairage ou d'affichage d'images comprenant un réseau de ces diodes partageant le même substrat.

Comme l'enseigne le document EP0498979 - TOSHIBA - voir page 2 - une telle couche organique dopée permet d'injecter et de transporter les charges électriques entre l'électrode au contact de laquelle elle est et la couche électroluminescente avec une résistance électrique bien moindre qu'en utilisant une couche organique d'injection et une couche organique de transport non dopées. La tension d'alimentation des diodes de ce type est alors sensiblement abaissée et leur rendement lumineux amélioré.

L'avantage de l'utilisation de couches organiques dopées pour injecter et transporter des charges, électrons ou trous, dans la couche émissive électroluminescente, au lieu de couches d'injection et de transport de charges de l'art antérieur, est double ; on obtient en effet à la fois :
- une réduction de la barrière d'injection de charges,
- et une diminution des pertes ohmiques dans les couches d'injection et de transport de charges, puisque ces couches présentent une conductivité élevée du fait du dopage.

Pour conférer les caractéristiques électriques requises aux matériaux organiques utilisés pour les couches d'injection et de transport d'électrons entre l'électrode servant de cathode et la couche électroluminescente, on utilise des éléments dopants, organiques ou inorganiques, qui sont adaptés pour créer des niveaux d'énergie dits donneurs au voisinage du LUMO (Lowest Unoccupied Molecular Orbital) de ce matériau.

Dans le cas d'une couche en matériau organique dopé qui est en contact avec une électrode servant de cathode, qui est intercalée entre cette cathode et la couche électroluminescente, et qui est donc dopée avec un dopant donneur, le document US6013384 décrit l'utilisation de différents matériaux organiques dont la bathophénanthroline (= « Bphen »), et l'utilisation de différents dopants, dont les éléments alcalino-terreux comme le calcium. L'épaisseur de la couche organique dopée est comprise entre 1 et 300 nm, et des concentrations supérieures à 0,1 % en poids sont préconisées, par exemple 1,4 % en poids. Le document US6013384 enseigne que la relation entre le dopage et la diminution de la hauteur de la barrière électronique au contact avec l'électrode résulte de réactions d'oxydo-réduction entre le matériau « hôte » et le dopant.

Le document US6821649 - TDK, qui propose également une solution pour abaisser la barrière de potentiel entre la cathode et la couche électroluminescente d'une diode, cite lui-même le document JP10-270171 qui décrit l'utilisation de tris(8-quinolinolato)aluminum (= « Alq3 ») dopé au lithium ou au magnésium, ou de bathophénanthroline (= « Bphen ») dopé au lithium pour cette couche organique dopée au contact de la cathode.

Le document US2002-055015 décrit également (§ 59 - 60) l'utilisation de la bathophénanthroline (= « Bphen ») dopée avec un élément alcalin pour les couches d'injection et de transport d'électrons.

Le document J. Kido et al., Appl. Phys. Lett., vol. 73, no. 20, pg. 2866 à 2668 (16.11.1998) décrit le procédé de dopage contrôlé d'une couche BPhen par Sm ou Sr d'une diode électroluminescente.

Pour le dopage des matériaux organiques de cette couche d'injection et/ou de transport des électrons, il est donc connu d'utiliser un élément alcalin ou un élément alcalino-terreux. Du point de vue des performances de la diode, on préfère l'élément alcalin ; mais l'élément alcalin est difficile à déposer sans qu'il ne se combine, notamment avec l'une ou l'autre des composants organiques de base de la couche, pour former des composant organométalliques ; l'élément alcalino-terreux est plus facile à introduire dans le matériau que l'élément alcalin, car il s'évapore moins facilement lors du dépôt, mais son effet dopant semblait jusqu'ici moindre, en ce sens qu'il abaisse moins qu'un élément alcalin la barrière de potentiel entre la couche organique électroluminescente émissive et la cathode, et que l'amélioration de la durée de vie qu'il apporte est moindre que celle apportée par le dopage par un élément alcalin.

Un but de l'invention est d'obtenir simultanément les deux avantages :
- facilité d'introduction du dopant dans le matériau organique de la couche au contact de la cathode,
- abaissement important de la barrière de potentiel et amélioration de la durée de vie de la diode.

A cet effet, l'invention a pour objet un procédé de fabrication d'une diode organique électroluminescente comprenant les étapes suivantes :
- obtenir un empilement comprenant :
   - une électrode inférieure d'un premier genre déposée sur un substrat ;
   - une couche organique électroluminescente émissive déposée sur ladite électrode inférieure ;
   - une électrode supérieure d'un second genre déposée sur ladite couche organique électroluminescente émissive, les genres d'électrodes correspondant à anode et cathode ;
   - et, déposée entre ladite cathode et ladite couche organique électroluminescente émissive, une couche en matériau organique en contact avec ladite cathode, le matériau organique étant à base de bathophénanthroline, le matériau organique étant dopé en élément donneur avec un niveau de dopage contrôlé au cours du dépôt de la couche en matériau organique, l'élément présentant une fonction de travail inférieure à 4 eV, l'élément donneur étant choisi dans le groupe formé par les éléments alcalino-terreux et les lanthanides ;
   - soumettre ensuite l'empilement obtenu à un traitement thermique, la température du traitement thermique étant supérieure ou égale à 80 °C.

L'article intitulé « The work function of the elements and its periodicity », de Herbert B. Michaelson, de la Société IBM, publié le 11 novembre 1977 aux pages 4729 à 4733 dans « Journal of Applied Physics », Vol. 48, N°11, indique les valeurs de travail de sortie pour différents éléments de la classification de Mendeleïev ; cet article permet donc à l'homme du métier de déterminer des éléments qui présentent une fonction de travail inférieure à 4 eV.

De préférence, la durée dudit traitement thermique est supérieure ou égale à 1 h. On obtient ainsi une amélioration significative de l'efficacité du dopage par l'élément dopant de ladite couche organique dopée.

Dans l'article précité de Herbert B. Michaelson, on constate que les éléments alcalino-terreux et les lanthanides (du cérium au lutécium) présentent une fonction de travail inférieure à 4 eV.

De préférence, l'élément donneur est choisi dans le groupe formé par les éléments alcalino-terreux.

De préférence, l'élément donneur est choisi dans le groupe formé par le magnésium et le calcium. Avantageusement, ces éléments sont plus faciles à déposer sous vide, parce qu'ils se subliment sous vide.

Le matériau organique qui est dopé en élément donneur est à base de bathophénanthroline.

De nombreux exemples de bathophénanthrolines sont donnés dans le document EP1097980 ; la dénomination courante abrégée de ce produit est le Bphen. On a constaté que, parmi les matériaux organiques qui sont susceptibles d'être dopés en éléments donneurs et d'être utilisés pour la couche organique dopée de la diode selon l'invention, c'est avec le Bphen qu'on obtenait la meilleure efficacité de dopage après traitement thermique.

De préférence, le niveau de dopage en dopant de ladite couche organique dopée est plus élevé à l'interface de cette couche avec la cathode, qu'au coeur de cette couche organique dopée.

Grâce à un niveau de dopage différent à l'interface avec la cathode et au coeur de la couche organique dopée, on peut à la fois diminuer l'épaisseur de la barrière de potentiel à l'interface et augmenter la résistance électrique au coeur du matériau puisque le niveau de dopage est plus faible, ce qui permet d'optimiser à la fois les propriétés d'injection et les propriétés de transport des électrons de cette couche dopée. De préférence, il existe une barrière de potentiel supérieure à 0,2 eV audit interface. A température ambiante, cette interface forme donc une jonction Schottky.

Si le matériau de la cathode qui est à l'interface avec la couche organique dopée selon l'invention est un métal qui présente un travail de sortie E_{M1}, si le matériau O1 de ladite couche organique dopée n en donneurs à cette interface présente un niveau de Fermi E₁ et un niveau de LUMO (« Lowest Unoccupied Molecular Orbital » en langue anglaise) E_{C1}, alors on a | E_{C1} - E_{M1} |> 0.2 eV et E_{M1} > E₁ (la condition inverse E_{M1} < E₁ impliquerait au contraire un contact ohmique). Le mécanisme d'injection d'électrons à cette interface est alors le suivant : les électrons qui peuplent les niveaux « donneurs » à proximité de cette interface passent dans le métal M1, qui est un réservoir infini de charges et le dépeuplement des niveaux « donneurs » dans le matériau organique semiconducteur O1 à proximité de cette interface donne lieu à une charge locale positive qui forme une barrière de potentiel à l'interface et le niveau E_{C1} du LUMO présente alors une courbure à proximité de cette interface. L'épaisseur de cette barrière qui correspond à l'étendue de cette courbure est de l'ordre que quelques nanomètres. Quand on applique une différence de potentiel à la diode dans le sens passant pour émettre de la lumière, les électrons traversent cette barrière par effet tunnel.

Plus généralement, on peut également définir pour le matériau organique dopé O1 l'énergie E1 du niveau de Fermi, et celle E_{V1} du niveau du HOMO (« Highest Occupied Molecular Orbital » en langue anglaise) ; le dopage n en niveaux donneurs de ce matériau se traduit par la relation : E₁ - E_{C1} < E_{V1} - E₁,

De préférence, la diode comprend une couche organique de blocage de trous intercalée entre ladite couche organique dopée et ladite couche électroluminescente. De préférence, l'épaisseur de cette couche est supérieure ou égale à 5 nm. Le matériau de base de la couche de blocage de trous peut être de même nature que le matériau de base de la couche organique dopée, mais sans être dopé en élément donneur. Dans le cas où le traitement thermique selon l'invention ferait migrer l'élément donneur dans cette couche de blocage, les conditions d'épaisseur initiale de cette couche et du traitement thermique sont de préférence adaptées pour que l'épaisseur non dopée en élément donneur de la couche de blocage reste supérieure ou égale à 5 nm. Le document US2002-055015 décrit (exemple 1) une diode comprenant une couche de transport d'électrons à base de bathophénanthroline dopée au sodium, mais ne comprenant aucune couche de barrière de trous en matériau non dopé intercalée entre la couche électroluminescente et la couche de transport d'électrons, dopée en élément donneur ; ce document enseigne (§ 106) qu'après 96 heures à 60°C, les caractéristiques luminescentes de la diode restent « pratiquement acceptables », ce qui signifie qu'elles ne sont pas significativement améliorées, au contraire. Selon l'invention, l'amélioration des performances de la diode est plus importante lorsque la diode comprend une couche de barrière de trous en matériau non dopé en élément donneur qui est intercalée entre la couche électroluminescente et la couche dopée en élément donneur pour le transport des électrons. Cette amélioration est également plus importante lorsqu'on utilise un élément alcalino-terreux ou une terre rare plutôt que le sodium comme élément donneur dans la couche dopée de la diode.

De telles couches de blocage sont décrites dans le document EP1017118 - SHARP sous le nom de « restraining layers » en langue anglaise. De telles couches de blocage servent à limiter les recombinaisons électrons-trous en dehors de la couche électroluminescente, de manière à maintenir un rendement lumineux élevé. De telles couches de blocage sont particulièrement utiles lorsque la couche électroluminescente comprend des dopants phosphorescents qui permettent la recombinaison radiative des excitons électrons-trous dits « triplets » , car ces excitons ont une durée de vie qui leur permet de diffuser sur plusieurs centaines de nanomètres, ce qui rend le blocage des électrons ou trous d'autant plus utile pour éviter les recombinaisons non radiatives. On se référera par exemple à l'article intitulé « High-Efficiency Organic Light-Emitting Diodes », des auteurs N.K. Patel, S. Cina et J.H. Burroughes, dans « IEEE Journal on selected topics in quantum electronics », Vol.8, N°2, Mars-Avril 2002, pp.346-361, qui décrit l'importance des triplets et des dopants phosphorescents pour améliorer l'efficacité lumineuse des diodes organiques électroluminescentes.

La diode électroluminescente obtenue par le procédé inventif peut être utilisée dans un panneau d'éclairage ou d'affichage d'images comprenant un réseau de diodes selon l'invention, où les diodes de ce réseau sont supportées par le même substrat.

De préférence, ledit substrat est une matrice active comprenant un réseau de circuits de commande et d'alimentation.

De préférence, les électrodes inférieures de ces diodes sont des cathodes ; chaque circuit de commande et d'alimentation correspond à une diode du panneau et comprend alors un transistor de type n de modulation de courant qui est relié en série avec cette diode.

La combinaison de cette structure dite « inversée » et d'un transistor de modulation de type n permet d'assurer à chaque transistor de commander une diode indépendamment de la chute de tension aux bornes de cette diode.

De préférence, le substrat comprend une couche de matériau semiconducteur en silicium amorphe. Chaque transistor de modulation comprend alors une portion de cette couche de silicium.

L'invention sera mieux comprise à la lecture de la description qui va suivre, donnée à titre d'exemple non limitatif, et en référence aux figures annexées sur lesquelles :

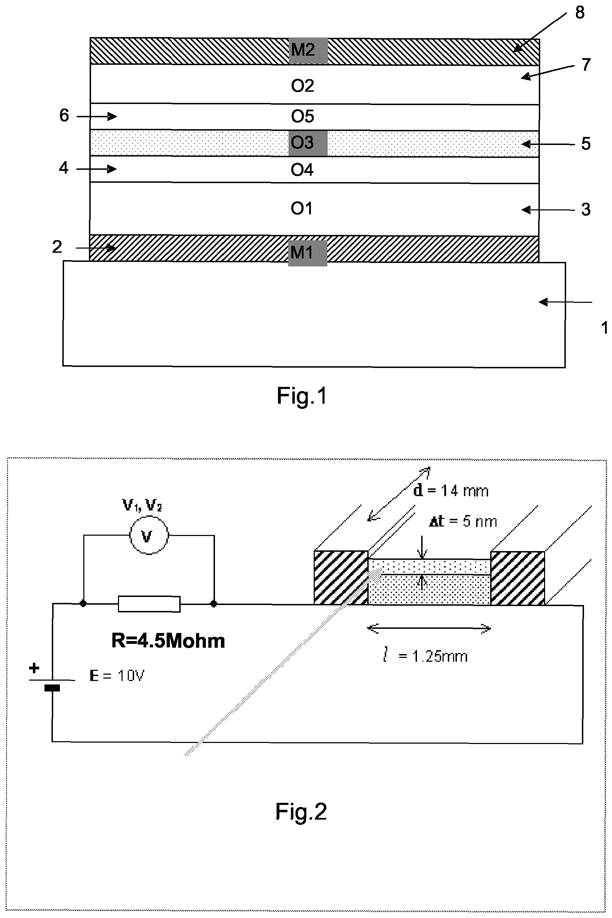

- la figure 1 illustre un mode de réalisation d'une diode fabriquée selon le procédé de l'invention;
- la figure 2 illustre schématiquement un montage électrique permettant d'évaluer l'évolution de la conductivité planaire d'une couche organique dopée pendant que son épaisseur augmente, donc en cours de dépôt ;

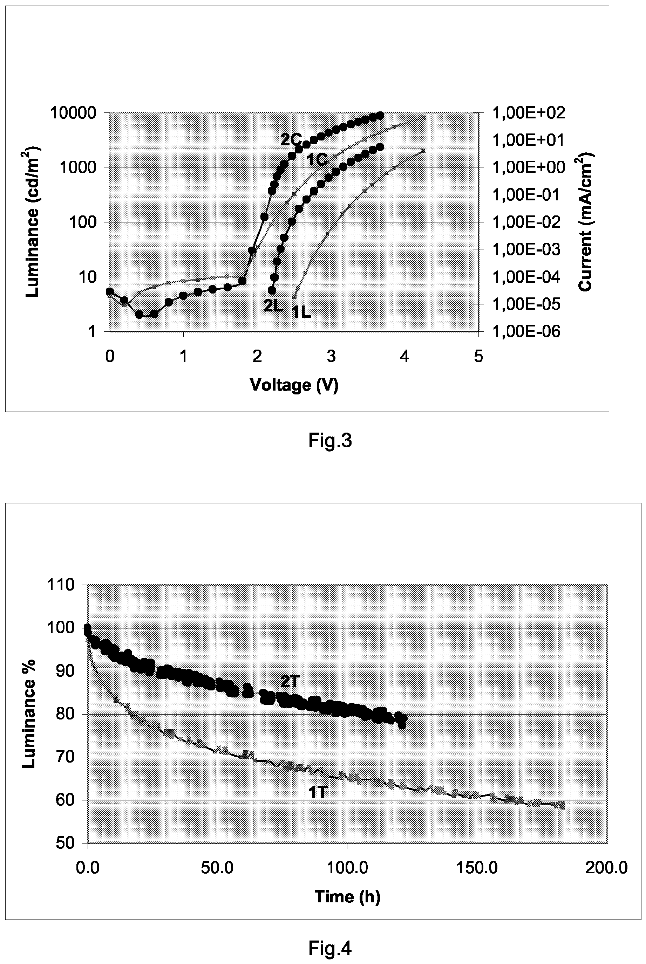

- la figure 3 montre les caractéristiques courant-tension (courbes 1C et 2C qui rapportent à l'axe des ordonnées à droite - mA/cm²) et les performances de luminance (courbes 1L et 2L qui rapportent à l'axe des ordonnées à gauche - cd/m²) d'une diode selon un exemple de diode (courbes référencées 2) conforme au mode de réalisation de la figure 1 par comparaison à une diode présentant la même structure de l'art antérieur (courbes référencées 1), sans traitement thermique postérieur de la diode ;

- la figure 4 montre la durée de vie, plus précisément l'évolution de la luminance (cd/m²) en fonction du temps (heures) d'une diode selon un exemple de diode (courbe référencée 2) conforme au mode de réalisation de la figure 1 par comparaison à une diode présentant la même structure de l'art antérieur (courbe référencée 1), sans traitement thermique postérieur de la diode ; les mesures sont faites à courant constant de 27 mA/cm² ; la base « 100 » en début de vie correspond approximativement à 800 cd/m² ;

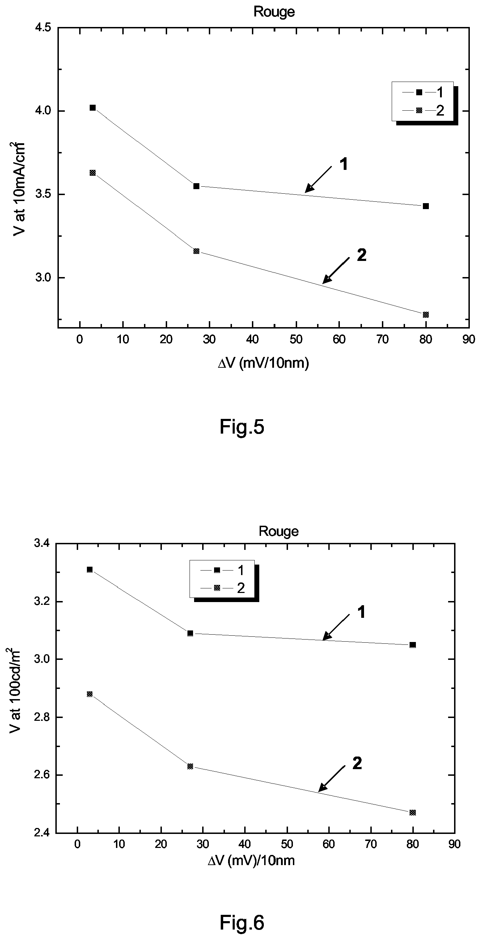

- les figures 5 et 6 illustrent l'évolution de la tension d'alimentation nécessaire pour obtenir un courant de 10 mA/cm² (fig.5) ou une émission rouge de 100 cd/m² (fig.6) dans une diode fabriquée selon le procédé inventif avec traitement thermique de 80°C pendant 48 h (courbes 2) et dans une diode selon l'art antérieur, identique mais sans traitement thermique postérieur (courbes 1), en fonction du niveau de dopage évalué, comme décrit ultérieurement, par le facteur ΔV exprimé en mV/10.nm.

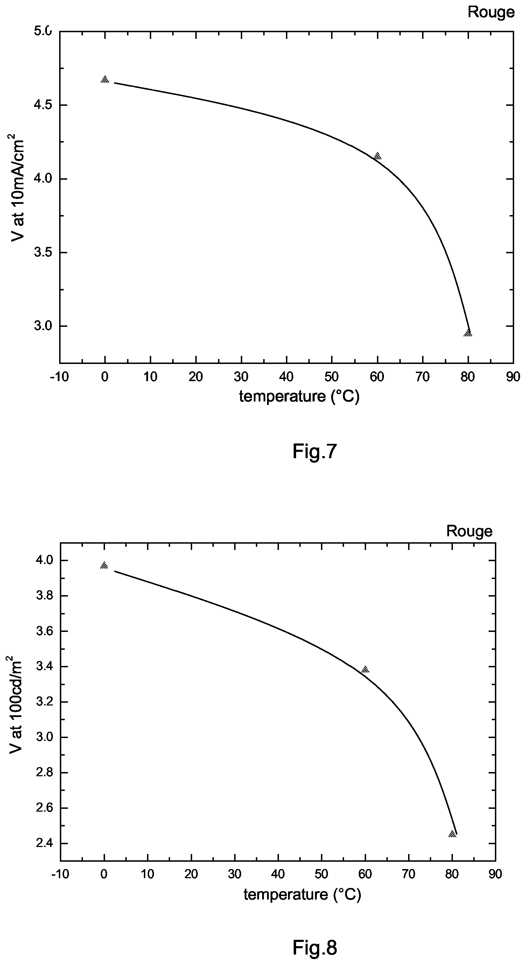

- les figures 7 et 8 illustrent l'évolution de la tension d'alimentation nécessaire pour obtenir un courant de 10 mA/cm² (fig.7) ou une émission de 100 cd/m² (fig.8) dans une diode, qui est dotée d'une couche électroluminescente émettant dans le rouge, et qui est réalisée selon le procédé de l'invention avec un traitement thermique final de 48 h, en fonction de la température dudit traitement thermique (°C).

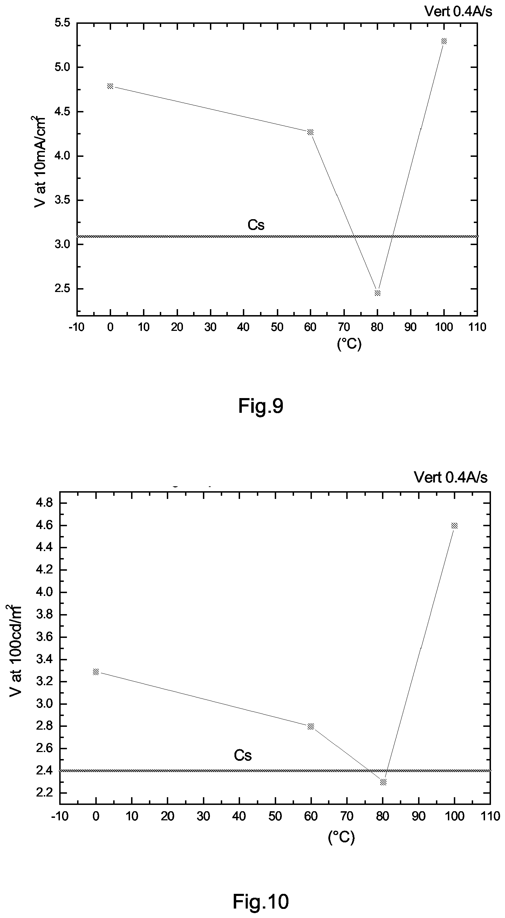

- les figures 9 et 10 illustrent l'évolution de la tension d'alimentation nécessaire pour obtenir un courant de 10 mA/cm² (fig.9) ou une émission de 100 cd/m² (fig.10) dans une diode, qui est dotée d'une couche électroluminescente émettant dans le vert, et qui est réalisée selon le procédé de l'invention avec un traitement thermique final de 48 h, en fonction de la température dudit traitement thermique (°C).

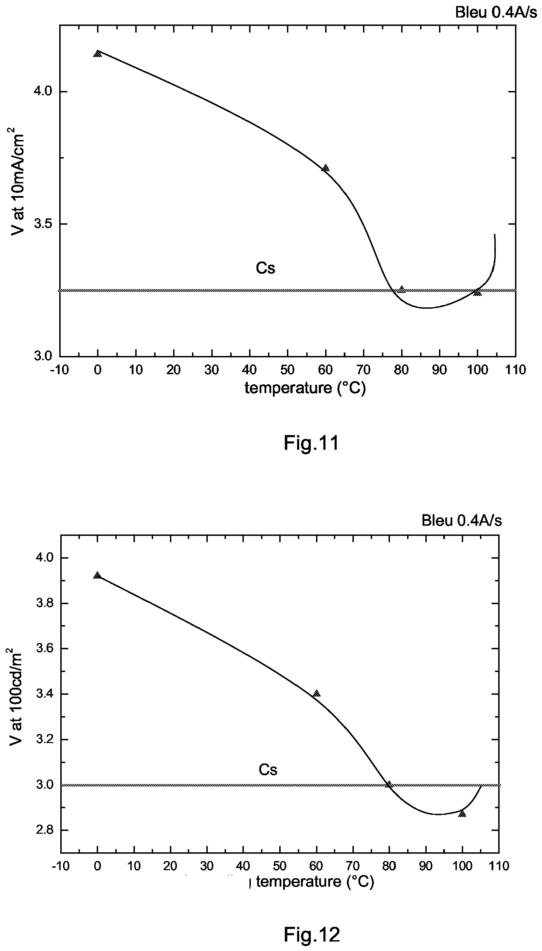

- les figures 11 et 12 illustrent l'évolution de la tension d'alimentation nécessaire pour obtenir un courant de 10 mA/cm² (fig.11) ou une émission de 100 cd/m² (fig.12) dans une diode, qui est dotée d'une couche électroluminescente émettant dans le bleu, et qui est réalisée selon le procédé de l'invention avec un traitement thermique final de 48 h, en fonction de la température dudit traitement thermique (°C).

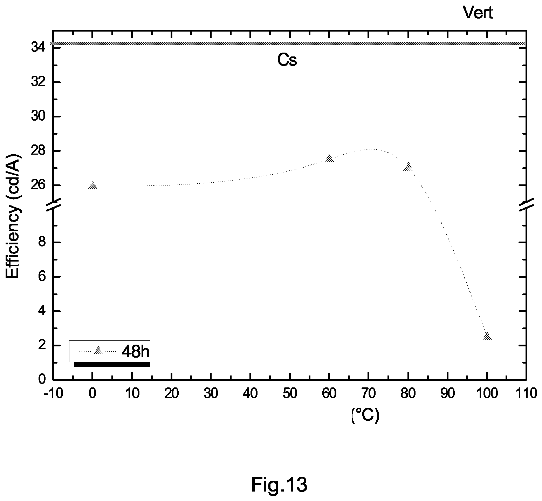

- la figure 13 donne l'évolution de l'efficacité lumineuse (cd/A) des diodes émettant dans le rouge qui sont caractérisées aux figures 7 et 8, en fonction de la température du traitement thermique final de ces diodes (°C).

On va maintenant décrire la fabrication d'une diode selon un mode de réalisation de l'invention en se référant à la figure 1.

Sur un substrat de verre 1, on dépose une couche 2 de matériau conducteur M1 pour servir d'anode en électrode inférieure ; ce matériau conducteur M1 est par exemple de l'ITO (« Indium Tin Oxide » en langue anglaise) déposé par pulvérisation cathodique sous vide.

Sur cette couche 2, on dépose au moins une couche organique inférieure dopée 3, en matériau organique O1 dopé en éléments accepteurs, donc dopé p, par exemple l'une et/ou l'autre des couches suivantes :
- 100 nm de Spiro-TTB (produit fourni par la Société COVION), dopé à 2% en poids avec du NDP2 (produit fourni par la Société NOVALED);
- 50 nm de PEDOT-PSS ; le PEDOT-PSS est un mélange de PEDOT (poly-3,4-éthylène dioxythiophène) et de PSS (poly-styrène sulfonate) ; il est dopé p en éléments accepteurs, d'une manière connue en elle-même, notamment via le PSS.

Pour contrôler le niveau de dopage des différentes couches organiques de la diode en cours de fabrication, on utilise la méthode ci-après basée sur une mesure de conductivité planaire de cette couche en cours de dépôt. Cette méthode donne ici un résultat évalué en mV par dizaine de nanomètre d'épaisseur déposée (mV/10.nm) ; pour un matériau « hôte » avec son dopant et une vitesse de dépôt donnés (Â/s), le niveau de dopage de la couche est proportionnel au résultat obtenu.

Pour contrôler le niveau de dopage de la couche 3 en matériau O1, on utilise par exemple le montage de la figure 2, où, dans l'enceinte de dépôt, le matériau O1 est simultanément déposé entre deux électrodes métalliques (section hachurée sur la figure) qui sont distantes de I = 1,25 mm, s'étendent sur une distance d = 14 mm, et qui sont reliées à un dispositif de mesure de résistance. Ce dispositif comprend ici un générateur de tension continue E = 10 V et une résistance étalon R = 4,5 MΩ reliés en série ; on mesure la tension aux bornes de la résistance étalon donne la valeur de résistance entre les deux électrodes ; l'évolution de cette tension en fonction du temps (mV/s) rapportée à la vitesse de dépôt (Â/s) donne un résultat (exprimé en mV/10.nm) considéré comme proportionnel au taux de dopage de la couche. Afin d'assurer le niveau de dopage qui convient, on adapte de préférence la proportion de dopant au moment du dépôt du matériau O1 ; un dopage de l'ordre de 1% à 2% en poids convient généralement.

Sur la couche 3 en matériau organique O1 dopée en éléments accepteurs, on dépose une couche de blocage 4 des électrons en matériau organique O4, d'une manière connue en elle-même.

Sur cette couche de blocage 4 des électrons, on dépose ensuite une couche organique électroluminescente 5 en matériau O3 ; ce matériau O3 n'est généralement pas dopé en éléments donneurs ou accepteurs ; ce matériau O3 est de préférence dopé par un dopant fluorescent et/ou phosphorescent comme illustré par exemple dans l'article « « High-Efficiency Organic Light-Emitting Diodes » - IEEE journal - déjà cité.

Sur cette couche organique électroluminescente 5, on dépose une couche de blocage 6 des trous en matériau organique O5, d'une manière connue en elle-même.

Sur cette couche de blocage 6 des trous, on dépose une couche organique supérieure dopée 7, en matériau O2 dopé en éléments donneurs, donc dopé n. Ici, la concentration en dopant donneur est approximativement constante dans toute l'épaisseur de cette couche. Selon une variante, la concentration en dopant donneur est beaucoup plus élevée à l'interface avec l'électrode 8 qui va la revêtir qu'au coeur de ce matériau O2. Le contrôle du niveau de dopage précédemment décrit est effectué pour la couche 7 en matériau O2.

Sur cette couche organique supérieure dopée 7, on dépose une couche de métal M2, pour servir d'électrode supérieure 8, ici une cathode.

On soumet ensuite l'empilement obtenu à un traitement thermique à 80°C pendant 24 heures.

On obtient ainsi une diode selon le procédé de l'invention.

Grâce au traitement thermique selon l'invention, on constate une amélioration sensible des performances de la diode et de sa durée de vie, qui est illustrée par l'exemple ci-après. Cette amélioration traduit l'abaissement important de la barrière de potentiel entre la cathode et la couche organique électroluminescente qui peut être obtenue avec des dopants alcalino-terreux, notamment le calcium, qui sont plus faciles à mettre en oeuvre que les dopants alcalins de l'art antérieur ; on obtient également une réduction avantageuse de la résistivité de la couche 7.

### Exemple 1 d'un procédé inventif :

La diode présentée dans cet exemple présente la même structure que celle du mode de réalisation qui vient d'être décrit.

Du bas vers le haut en partant du substrat 1, cette diode présente les couches suivantes :
- couche métallique 2 en ITO d'épaisseur 150 nm environ ;
- couche organique inférieure dopée 3 : 100 nm de Spiro-TTB (produit fourni par la Société COVION), dopé à 2% en poids avec du NDP2 (produit fourni par la Société NOVALED);
- couche de blocage des électrons 4 dénommé « SPIRO TAD » de la Société COVION, d'épaisseur 10 nm,
- couche électroluminescente 5 d'épaisseur 20 nm, susceptible d'émettre un rayonnement de teinte rouge ; les matériaux pour cette couche proviennent de la Société COVION : produit dénommé en 2004 « TMM-004 » dopé à 20% en poids avec un dopant phosphorescent dénommé en 2004 « TER-004 » ;
- couche de blocage de trous 6 en 4,7-diphényl-1,10-phénanthroline (Bphen), non dopé, d'épaisseur 10 nm ;
- couche organique supérieure dopée 7 en « Bphen » (Société COVION) dopé n avec du calcium, d'épaisseur 50 nm ; le niveau de dopage est adapté pour obtenir une variation de conductivité, selon la méthode précédemment décrite, de 80 mV/10 nm ; ce niveau de dopage est approximativement constant dans toute l'épaisseur de la couche ;
- couche métallique en aluminium pour servir de cathode 8, d'épaisseur 200 nm environ, qui sert également de couche d'encapsulation et de protection.

On soumet ensuite l'empilement obtenu à un traitement thermique à 80°C pendant 24 heures.

On obtient ainsi la diode selon l'exemple 1.

Les caractéristiques courant-tension, les caractéristiques luminance-tension, et les caractéristiques luminance-temps de cette diode, ont été reportées respectivement sur la figure 3 (pour les deux premières caractéristiques) et sur la figure 4 , sur des courbes référencées respectivement 2C, 2L, et 2T.

### Exemple comparatif 1 :

A titre d'exemple comparatif, on a réalisé une diode identique à celle de l'exemple 1, à la seule différence prés qu'aucun traitement thermique postérieur aux dépôts n'a été réalisé.

Les caractéristiques courant-tension, les caractéristiques luminance-tension, et les caractéristiques luminance-temps de cette diode, ont été reportées respectivement sur la figure 3 (pour les deux premières caractéristiques) et sur la figure 4, sur des courbes référencées respectivement 1C, 1L, et 1T.

En comparant les résultats de la diode de l'exemple 1 à ceux de la diode de l'exemple comparatif 1, on constate que le traitement thermique selon l'invention permet de diminuer sensiblement la tension d'alimentation requise pour obtenir un courant prédéterminé, et donc un éclairement prédéterminé, puisque :
- la tension requise pour obtenir un éclairement de 1000 cd/m² passe de 4 V dans l'exemple comparatif 1 à seulement 3,1 V dans l'exemple 1 selon l'invention ;
- la tension requise pour obtenir un éclairement de 100 cd/m² passe de 3 V dans l'exemple comparatif 1 à seulement 2,5 V dans l'exemple 1 selon l'invention.

On obtient donc pour la diode fabriquée selon le procédé de l'invention des performances équivalentes à celles qu'on obtiendrait avec un dopage de la couche organique supérieure 7 avec un élément alcalin, comme dans l'art antérieur, par exemple le césium.

Par ailleurs, en référence à la figure 4, on constate que, grâce au traitement thermique selon l'invention, on améliore sensiblement la durée de vie de la diode.

### Exemples 2 d'un procédé inventif et exemples comparatifs 2 :

Ces exemples ont pour but d'optimiser la concentration en élément dopant dans la couche organique supérieure 7 d'une part pour des diodes qui sont identiques à celles de l'exemple 1 à la différence près du taux de dopant et du traitement thermique final dont la durée est doublée (48 h au lieu de 24 h - température identique de 80°C), d'autre part pour des diodes qui sont identiques à celles de l'exemple comparatif 1 à la différence près du taux de dopant.

Les figures 5 et 6 illustrent l'évolution de la tension d'alimentation nécessaire pour obtenir un courant de 10 mA/cm² (fig.5) ou une émission rouge de 100 cd/m² (fig.6) dans ces diodes fabriquée selon le procédé des exemples 2 (courbes 2) et dans ces diodes selon l'art antérieur, en fonction du niveau de dopage dans la couche organique supérieure 7, qui est évalué, comme décrit précédemment, par le facteur ΔV exprimé en mV/10 nm.

On constate qu'un niveau de dopage de 80 mV/10 nm donne les meilleurs résultats.

### Exemples 3 :

Ces exemples ont pour but d'optimiser la température du traitement thermique final pour des diodes, qui sont identiques à celles de l'exemple 1 à la différence près du traitement thermique final dont la température est variable et la durée doublée (48 h au lieu de 24 h). Le niveau de dopage de la couche organique supérieure 7 est identique à celui de l'exemple 1 (80 mV/10.nm).

Les figures 7 et 8 illustrent l'évolution de la tension d'alimentation nécessaire pour obtenir un courant de 10 mA/cm² (fig.7) ou une émission de 100 cd/m² (fig.8) dans ces diodes en fonction de la température du traitement thermique (°C).

On constate une amélioration significative dès lors que la température de traitement thermique est supérieure ou égale à 60°C ; on constate qu'un traitement thermique à 80°C apporte les meilleurs résultats.

### Exemples 4 :

Ces exemples ont pour but d'optimiser la température du traitement thermique final pour des diodes qui sont identiques à celles de l'exemple 1 à la différence près du traitement thermique final dont la température est variable et la durée doublée (48 h au lieu de 24 h) et du matériau de la couche électroluminescente 5, qui est adapté ici pour obtenir une émission de couleur verte : on prend par exemple la produit TMM 004 précédemment décrit dopé cette fois à 15% en poids avec un produit dénommé Ir(ppy)₃. Le niveau de dopage de la couche organique supérieure 7 est identique à celui de l'exemple 1 (80 mV/10.nm).

Le produit Ir(ppy)₃ correspond à la formule développée suivante :

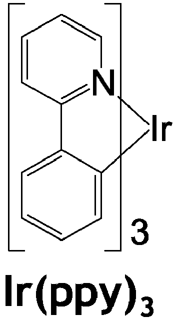

Les figures 9 et 10 illustrent l'évolution de la tension d'alimentation nécessaire pour obtenir un courant de 10 mA/cm² (fig.9) ou une émission de 100 cd/m² (fig.10) dans ces diodes en fonction de la température du traitement thermique (°C).

Là aussi, on constate une amélioration significative dès lors que la température de traitement thermique est supérieure ou égale à 60°C ; on constate qu'un traitement thermique à 80°C apporte les meilleurs résultats, et qu'à 90°C, les performances de la diode se détériorent.

### Exemple comparatif 3

Sur les figures 9 et 10, les courbes horizontales en traits gras référencées Cs indiquent les performances d'une diode identique à celle de l'exemple comparatif 1 aux différences près que le matériau de la couche électroluminescente 5 est identique à celui des exemples 4 (émission verte) et que le dopant de la couche organique supérieure 7 est du césium (au lieu du calcium), à un niveau de dopage qui est optimisé et correspond à une mesure de 15 mV/10.nm (mesure selon conditions précédemment décrites).

On constate donc que les meilleures diodes de l'exemple 4 fabriquées selon le procédé de l'invention (traitement thermique à 80°C) ont des performances comparables à des diodes classiques de l'art antérieur dotées de couches organiques d'injection et/ou de transport, dopées au césium.

### Exemples 5 :

Ces exemples ont pour but d'optimiser la température du traitement thermique final pour des diodes, qui sont identiques à celles de l'exemple 1 à la différence près du traitement thermique final dont la température est variable et la durée doublée (48 h au lieu de 24 h) et du matériau de la couche électroluminescente 5, qui est adapté ici pour obtenir une émission de couleur bleue, est qui est par exemple un matériau dénommé SEB010 dopé à 2% en poids avec un matériau dénommé SEB021. Le niveau de dopage de la couche organique supérieure 7 est identique à celui de l'exemple 1 (80 mV/10.nm).

Les figures 11 et 12 illustrent l'évolution de la tension d'alimentation nécessaire pour obtenir un courant de 10 mA/cm² (fig.11) ou une émission de 100 cd/m² (fig.12) dans ces diodes en fonction de la température du traitement thermique (°C).

On constate une amélioration significative dès lors que la température de traitement thermique est supérieure ou égale à 60°C ; on constate qu'un traitement thermique supérieur ou égal à 80°C apporte les meilleurs résultats, et qu'à 100°C, les performances de la diode restent optimales.

### Exemple comparatif 4

Sur les figures 11 et 12, les courbes horizontales en traits gras référencées Cs indiquent les performances d'une diode identique à celle de l'exemple comparatif 1 aux différences près que le matériau de la couche électroluminescente 5 est identique à celui des exemples 5 (émission bleue) et que le dopant de la couche organique supérieure 7 est du césium (au lieu du calcium) à un niveau de dopage qui est optimisé et correspond à une mesure de 15 mV/10.nm (mesure selon conditions précédemment décrites).

On constate donc que les meilleures diodes de l'exemple 5 selon l'invention (traitement thermique supérieur ou égal à 80°C) ont des performances comparables à des diodes classiques de l'art antérieur dotées de couches organiques d'injection et/ou de transport, dopées au césium.

Le procédé de la présente invention a été décrit en se référant à une diode comprenant à la fois une couche organique dopée inférieure et une couche organique dopée supérieure, où l'électrode inférieure est une anode et l'électrode supérieure est une cathode ; il est évident pour l'homme du l'art qu'il peut s'appliquer à d'autres types de diodes sans sortir du cadre des revendications ci-après, notamment des diodes où l'électrode inférieure est une cathode et l'électrode supérieure est une anode.

## Revendications

1. Procédé de réalisation d'une diode électroluminescente, comportant les étapes :
- obtenir un empilement comprenant :
- une électrode inférieure d'un premier genre (2) déposée sur un substrat (1),
- une couche organique électroluminescente émissive (5) déposée sur ladite électrode inférieure (2) ;
- une électrode supérieure d'un second genre (8) déposée sur ladite couche organique électroluminescente émissive (5), les genres d'électrodes correspondant à anode et cathode,
- et, déposée entre ladite cathode et ladite couche organique électroluminescente émissive (5), une couche (7) en matériau organique en contact avec ladite cathode, le matériau organique étant à base de bathophénanthroline, le matériau organique étant dopé en élément donneur avec un niveau de dopage contrôlé au cours du dépôt de la couche (7) en matériau organique, l'élément donneur étant choisi dans le groupe formé par les éléments présentant une fonction de travail inférieure à 4 eV, l'élément donneur étant choisi dans le groupe formé par les éléments alcalino-terreux et les lanthanides
le procédé étant **caractérisé par le fait qu'**il comprend l'étape suivante:
• soumettre ensuite l'empilement obtenu à un traitement thermique, la température du traitement thermique étant supérieure ou égale à 80°C.

2. Procédé selon la revendication 1, **caractérisé en ce que** la durée dudit traitement thermique est supérieure ou égale à 1h.

3. Procédé selon la revendication 1 ou 2, dans lequel l'élément donneur est choisi dans le groupe formé par le magnésium et le calcium.

4. Procédé selon l'une des revendications 1 à 3, comportant une étape consistant à intercaler une couche de blocage des trous (6), qui est en matériau non dopé par l'élément donneur, entre la couche (7) en matériau organique et la couche organique électroluminescente émissive (5), la couche de blocage des trous (6) présentant une épaisseur supérieure ou égale à 5 nm.

## Patentansprüche

1. Verfahren zur Herstellung einer Leuchtdiode, umfassend die folgenden Schritte:
- Herstellung eines Stapels, umfassend:
- eine untere Elektrode einer ersten Gattung (2), die auf ein Substrat (1) aufgebracht ist,
- eine emissive organische Leuchtschicht (5), die auf die untere Elektrode (2) aufgebracht ist;
- eine obere Elektrode einer zweiten Gattung (8), die auf die emissive organische Leuchtschicht (5) aufgebracht ist, wobei die Elektrodengattungen einer Anode und einer Kathode entsprechen,
- sowie eine Schicht (7) aus einem organischen Material, die in Kontakt mit der Kathode zwischen der Kathode und der emissiven organischen Leuchtschicht (5) aufgebracht ist, wobei das organische Material auf Basis von Bathophenanthronil ist, und das organische Material mit einem Donorelement mit einem Dotierungsniveau dotiert ist, das während des Aufbringens der Schicht (7) aus organischem Material kontrolliert wird, wobei das Donorelement aus der Gruppe ausgewählt ist, die von den Elementen gebildet ist, die eine Arbeitsfunktion unter 4 eV aufweisen, und das Donorelement aus der Gruppe ausgewählt ist, die von den erdalkalischen Elementen und den Lanthaniden gebildet ist,
wobei das Verfahren **dadurch gekennzeichnet ist, dass** es den folgenden Schritt umfasst:
* anschließendes Unterziehen des hergestellten Stapels einer Wärmebehandlung, wobei die Temperatur der Wärmebehandlung größer oder gleich 80 °C ist.

2. Verfahren nach Anspruch 1, **dadurch gekennzeichnet, dass** die Dauer der Wärmebehandlung größer oder gleich 1 h ist.

3. Verfahren nach Anspruch 1 oder 2, bei dem das Donorelement aus der Gruppe ausgewählt ist, die von Magnesium und Kalzium gebildet ist.

4. Verfahren nach einem der Ansprüche 1 bis 3, umfassend einen Schritt, darin bestehend, eine Lochsperrschicht (6), die aus einem nicht mit dem Donorelement dotierten Material ist, zwischen die Schicht (7) aus organischem Material und die emissive organische Leuchtschicht (5) zwischenzufügen, wobei die Lochsperrschicht (6) eine Dicke größer oder gleich 5 nm aufweist.

## Claims

1. Method for fabricating a light-emitting diode, comprising the following steps:
- obtaining a stack comprising:
- a bottom electrode of a first kind (2) deposited on a substrate (1),
- an organic light-emitting layer (5) deposited on said bottom electrode (2),
- a top electrode of a second kind (8) deposited on said organic light-emitting layer (5), the kinds of electrodes corresponding to anode and cathode,
- and, deposited between said cathode and said organic light-emitting layer (5), a layer (7) of organic material in contact with said cathode, the organic material being made from bathophenanthroline, the organic material being doped with a donor element with a controlled doping level during deposition of the layer (7) of organic material, the donor element being chosen from the group formed by the elements presenting a work function lower than 4 eV, the donor element being chosen from the group formed by alkaline-earth elements and lanthanides,
the method being **characterised by** the fact that it comprises the following step:
- then subjecting the stack obtained to heat treatment, the temperature of the heat treatment being higher than or equal to 80° C.

2. Method according to claim 1, **characterised in that** the duration of said heat treatment is greater than or equal to 1 hr.

3. Method according to claim 1 or 2, wherein the donor element is selected from the group formed by magnesium and calcium.

4. Method according to one of claims 1 to 3, comprising a step consisting in incorporating a hole restraining layer (6), that is made from a material not doped by the donor element, between the layer (7) of organic material and the organic light-emitting layer (5), the hole restraining layer (6) presenting a thickness greater than or equal to 5 nm.
